# EUROPEAN PATENT APPLICATION

(11) **EP 1 260 607 A2**
(43) Date of publication of application: **27.11.2002**
(21) Application number: 02253442.4
(22) Date of filing: 15.05.2002
(51) Int. Cl.: C23C 18/20, C23C 18/42

(54) **Plating method**

(30) Priority: 25.05.2001 US 293662 P
(71) Applicant: Shipley Company LLC, Marlborough, MA 01752 (US)
(72) Inventor: Rzeznik, Maria Anna, Framingham, Massachusetts 01702 (US); Jacques, David L., Northbridge, Masssachusetts 01534 (US)
(74) Representative: Kent, Venetia Katherine

(57) **Abstract**

The present invention discloses compositions for increasing the adhesion of a layer of silver deposited from an immersion plating bath as well as methods of increasing the adhesion of silver layers obtained using these compositions. Such compositions and methods are particularly useful in the manufacture of electronic devices.

## Description

### Background of the Invention

The present invention relates generally to the field of metal plating. In particular, the present invention relates to the field of immersion silver metal plating.

Immersion or displacement plating is an electroless plating process, but is given a separate classification in the art. In immersion plating, deposition is by displacement of an elemental metal from a substrate by metal ions in a plating solution. In electroless plating deposition takes place primarily by autocatalytic reduction of metal ions from solution. Such electroless plating requires the presence of a reducing agent.

Immersion plating does not employ an external electric current but rather is an electrochemical displacement reaction which is driven by the position of the substrate metal in the electromotive series relative to the metal to be deposited from solution. Plating occurs when the dissolved metal ions in a plating bath are displaced by a more active (less noble) metal that is contacted with the plating bath.

In the manufacture of printed wiring boards, solderable finishes are typically applied to printed wiring board substrates having pads and/or through holes exposed through a mask, such as a soldermask. Such solderable finishes are often applied by immersion plating as electroless plating can also deposit metal on the surface of the mask, which is undesirable. As an immersion plating reaction is driven by the difference in electrochemical potentials, plating will only occur at areas of exposed metal. For example, U.S. Patent No. 5,143,544 (Iantosca) discloses a solution for immersion plating a tin-lead alloy suitable as a solderable finish on a printed wiring board substrate. However, there is a growing demand for more environmentally acceptable alternatives to lead for use in printed wiring board manufacture. Thus, the use of lead and lead alloys in electronic components faces an uncertain future. See, for example, U.S. Patent No. 5,536,908 (Etchells et al.).

Silver is a more environmentally acceptable alternative to lead and has been suggested for use as a solderable finish. As discussed above, the preferred method of depositing such a solderable finish is by immersion plating. For example, U.S. Patent No. 5,955,141 (Souter et al.) discloses certain immersion silver plating baths suitable for depositing a layer of silver on a printed wiring board,

One drawback of immersion silver plating is that the resulting silver deposit is typically poorly adherent. In conventional electrolytic and/or electroless silver plating processes, the substrate to be silver plated is typically pretreated with an agent to prevent immersion or displacement plating of silver during subsequent electrolytic or electroless silver plating. A wide variety of agents to reduce or prevent immersion deposition of silver are known.

U.S. Patent No. 4,452,673 (Takano) discloses a number of compounds, including benzotriazole and benzimidazole, as a pretreatment for preventing immersion deposition of silver from a silver electroplating bath. The object of this patent is to markedly suppress immersion silver plating on copper, nickel, iron or their alloys. This patent docs not disclose how to improve the adhesion of a silver deposit obtained from an immersion plating bath.

U.S. Patent No. 5,194,139 (Kinase et al.) discloses an acidic pretreatment solution for silver plating containing an acid and an agent to prevent silver deposition by displacement (i.e. immersion) from a high speed silver plating bath (i.e. an electrolytic plating bath). A long list of suitable agents for preventing immersion plating of silver is provided which includes nitrogen-containing heterocyclic compounds and their analogs. Specific nitrogen-containing heterocyclic compounds disclosed arc 2,2'-dipyridyl, benzotriazole, 1-hydroxybenzotriazole, and 5,6-dimethylbenzotriazole, among others. The goal of this patent is to inhibit immersion plating of silver as such immersion silver deposits show poor adherence which cannot be improved by subsequent electroplating,

Further, limitations on the use of immersion plating exist in printed wiring board manufacture. Such limitations include relatively slow plating rates and limited deposit thicknesses, which are due to the self-limiting nature of immersion plating, i.c. as the metal deposit builds, it tends to mask the underlying base metal, thereby preventing further displacement. These problems have conventionally been addressed using a broad range of additives in the immersion plating bath, such as rate enhancers. However, such additives may adversely affect other important characteristics of the deposit, such as adhesion and deposit uniformity.

Therefore, there is a need for a method of improving the adhesion of immersion plated silver deposits. There is a further need for methods that do not adversely affect other important characteristics of the silver deposit obtained from immersion plating baths.

### Summary of the Invention

It has been surprisingly found that pretreating a metal that is less electropositive than silver with an azole compound provides a subsequently immersion deposited layer of silver having improved adhesion as compared to silver deposits obtained from conventional immersion deposition methods without such a pretreatment step.

In one aspect, the present invention provides a method of improving the adhesion of a layer of silver deposited from an immersion plating bath including the step of contacting a metal that is less electropositive than silver with an azole compound prior to contacting the metal with an immersion silver plating bath to provide the layer of silver.

In another aspect, the present invention provides a method of depositing a layer of silver on a substrate including the steps of: contacting a metal that is less electropositive than silver with an azole compound; and then contacting the metal with an immersion silver plating bath to provide the layer of silver.

In a further aspect, the present invention provides a bath for promoting the adhesion of a layer of silver deposited from an immersion plating bath including an azole compound, water and a chelating agent.

In still a further aspect, the present invention provides a bath for promoting the adhesion of a layer of silver deposited from an immersion plating bath including an azole compound, water, a chelating agent, and a source of copper ions.

In yet another aspect, the present invention provides a method of manufacturing a printed wiring board including the steps of contacting a metal that is less electropositive than silver with an azole compound; and then contacting the metal with an immersion silver plating bath to provide a layer of silver.

In still another aspect, the present invention provides a method of improving the adhesion of a layer of silver deposited from an immersion plating bath including the step of contacting a metal that is less electropositive than silver with a microctching composition including water, an azole compound, and a microetchant selected from sulfuric acid/hydrogen peroxide or an alkali metal persulfate prior to contacting the metal with an immersion silver plating bath to provide the layer of silver.

In still a further aspect, the present invention provides a method of reducing tarnish of a layer of silver deposited from an immersion plating bath including the step of contacting a metal that is less electropositive than silver with an azole compound prior to contacting the metal with an immersion silver plating bath to provide the layer of silver.

### Detailed Description of the Invention

As used throughout this specification, the following abbreviations shall have the following meanings, unless the context clearly indicates otherwise: ° C = degrees centigrade; g = gram; L = liter; g/L = grams per liter; mL = milliliters; wt% = percent by weight; DI = deionized; cm = centimeters; v/v = volume per volume basis; and µin. = microinches.

The terms "printed circuit board" and "printed wiring board" are used interchangeably throughout this specification. As used throughout this specification, the term "complexing agent" includes ligands and chelating agents. "Halo" refers to fluoro, chloro, bromo and iodo. Unless otherwise noted, all amounts are percent by weight and all ratios are by weight. All numerical ranges are inclusive and combinable in any order, except where it is obvious that such numerical ranges are constrained to add up to 100%.

The present invention provides a method of improving the adhesion of a layer of silver deposited from an immersion plating bath including the step of contacting a metal that is less electropositive than silver with an azole compound prior to contacting the metal with an immersion silver plating bath to provide the layer of silver. The present invention provides a layer of silver deposited from an immersion plating bath having increased adhesion as compared to a layer of silver immersion deposited on a less electropositive metal that has not been first contacted with an azole compound. Surprisingly, the present invention also provides an immersion deposited layer of silver having increased adhesion as compared to an immersion silver bath containing an azole compound. Thus, more adherent silver deposits are obtained, which are less likely to flake or abrade off than conventional immersion silver deposits. The increased adhesion of silver deposits obtained according to the present invention also provides better surface mount connections between a printed wiring board and a surface mount device.

A wide variety of azole compounds may suitably be used in the present invention. Suitable azoles include, but are not limited to, triazoles, benzotriazoles, tetrazoles, imidazoles, benzimidazoles, indazoles and mixtures thereof. Such azoles may optionally be substituted. By "substituted azole" it is meant that one or more hydrogens of the azole are replaced by one or more other substituents. Suitable substituents include, but are not limited to, hydroxy, (C₁-C₁₆)alkyl, (C₁-C₆)alkoxy, (C₁-C₆)alkoxy(C₁-C₁₆)alkyl, hydroxy(C₁-C₁₆)alkyl, carboxylic acid, carboxaldehydc, (C₁-C₁₀)alkoxycarbonyl, amino, (C₁-C₆)alkylamino, (C₁-C₆)dialkylamino, aryl such as phenyl and tolyl, halo, thiol, (C₁-C₆)alkylthio, arylthio and the like. Such substituents may themselves by substituted. For example, a (C₁-C₁₆)alkyl may have one or more of its hydrogens replaced with another substituent group such as hydroxyl, carboxylic acid, amino and the like.

It is preferred that the azole compound is benzotriazole, substituted benzotriazole, imidazole or substituted imidazole, and more preferably benzotriazole, imidazole, (C₁-C₁₆)alkylimidazole, and arylimidazole. Phenylimidazole is the preferred arylimidazole. Exemplary (C₁-C₁₆)alkylimidazoles include methylimidazole, ethylimidazole, propylimidazole, hexylimidazole, decylimidazole and undecylimidazole. Suitable phenylimidazoles include 1-phenylimidazole and 4-phenylimidazole. Other suitable azoles include, but are not limited to, hydroxybenzotriazole, aminobenzotriazole, 2-imidazolecarboxaldehyde, benzotriazolecarboxylic acid, 2-guanidinobenzimidazole, 2-aminoindazole, chlorobenzotriazole, hydroxyethylbenzotriazole, hydroxyethylimidazole, hydroxybenzimidazole, 1,2,4-triazole, histidine, 1,2,4-triazolo[1,5-a]pyrimidine, and the like. It will be appreciated by those skilled in the art that mixtures of azole compounds may be advantageously used in the present invention. Such azole compounds are generally commercially available, such as from Aldrich Chemical Company (Milwaukee, Wisconsin) and may be used without furthex purification.

The azole compounds may be used in the present invention in a wide range of amounts. Typically, the azole compound is used in an amount of from 0.005 to 50 g/L, preferably from 0.005 to 20 g/L, and more preferably from 0.01 to 15 g/L. Particularly suitable amounts of azole compound are from 0.1 to 10 g/L, more particularly from 0.5 to 10 g/L, and even more particularly from 1 to 10 g/L. The specific amount of azole compound depends upon the particular azole chosen and its solubility in the pretreatment composition.

The pretreatment compositions of the present invention typically contain one or more azole compounds and water. Such pretreatment compositions may be alkaline or acidic. The pH of the pretreatment compositions may vary from 1 to 14, The pH of the pretreatment compositions may be varied in order to increase the solubility of the azole compound. For example, the solubility of hydroxybenzotriazole can be increased by increasing the pH of the pretreatment composition.

A wide variety of organic and inorganic acids can be used to adjust the pH of the pretreatment compositions. Suitable inorganic acids include, but are not limited to: hydrochloric acid, hydrofluoric acid, fluoroboric acid, hydroiodic acid, periodic acid, phosphoric acid, sulfuric acid, nitric acid, and the like. Suitable organic acids include, but are not limited to: alkylsulfonic acids such as methanesulfonic acid, trifuloromethanesulfonic acid, ethanesulfonic acid and propanesulfonic acid; arylsulfonic acids such as phenylsulfonic acid, naphthalenesulfonic acid, toluenesulfonic acid; and the like. Mixtures of acids, such as mixtures of inorganic acids, mixtures of organic acids or mixtures of inorganic and organic acids, may be advantageously used. The acids are typically present in the pretreatment compositions in an amount sufficient to provide the desired pH.

Similarly, a wide variety of inorganic and organic bases may be used to adjust the pH. Suitable inorganic bases include, but are not limited to, alkali metal hydroxides such as sodium hydroxide and potassium hydroxide, carbonates such as sodium carbonate and potassium carbonate, ammonium hydroxide, and the like. Suitable organic bases include, but are not limited to, tetraalkylammonium hydroxides, amines, and the like.

Preferably, the pretreatment compositions further include one or more chelating agents. Such chelating agents may be monodentate ligands, such as ammonia, cyanide, pyridine and the like, or multidentate ligands. Suitable multidentate ligands include, but are not limited to: amino acids having from 2 to 10 carbon atoms; polycarboxylic acids such as oxalic acid, adipic acid, succinic acid, malonic acid and maleic acid; amino acetic acids such as nitrilotriacetic acid, pyridine carboxylic acid and pyridine dicarboxylic acid; alkylene polyamine polyacetic acids such as ethylenediamine tetraacetic acid ("EDTA"), diethylenetriamine pentaacetic acid ("DTPA"), N-(2-hydroxyethyl)ethylenediamine triacetic acid, 1,3-diamino-2-propanol-N,N,N',N'-tetraacetic acid, bis-(hydroxyphenyl)-ethylenediamine diacetic acid, diaminocyclohexane tetraacetic acid, or ethylene glycol-bis-((β-aminoethylether)-N,N'-tetracetic acid); polyamines such as or N,N,N',N'-tetrakis-(2-hydroxypropyl)ethylenediamine, ethylenediamine, 2,2',2"-triaminotriethylamine, triethylenetetramine, diethylenetriamine and tetrakis(aminocthyl)ethylenediamine; citrates; tartrates; N,N-di-(2-hydroxyethyl)glycine; gluconates; lactates; crown ethers; cryptands; polyhydrie compounds such as 2,2',2"-nitrilotrictlaanol; heteroaromatic compounds such as 2,2'-bipyridine, 1,10-phenanthroline and 8-hydroxyquinoline; thio-containing ligands such as thioglycolic acid and diethyldithiocarbamate; aminoalcohols such as ethanolamine, diethanolamine, and tricthanolamine; and the like. It will be appreciated by those skilled in the art that a combination of chelating agents may be employed in the present invention. Preferably, the chelating agents are the same as those used in the subsequent immersion silver plating bath.

In one embodiment, the present invention provides a bath for promoting the adhesion of a layer of silver deposited from an immersion plating bath including an azole compound, water and a chelating agent.

Other additional components may optionally be used in the pretreatment compositions. Such additional components include, but are not limited to, surfactants, metal ions, and the like. The surfactants maybe anionic, cationic, nonionic or amphoterie. Preferably, the surfactants are cationic or nonionic. When a surfactant is used in the present pretreatment compositions, it is typically present in an amount of at least 0.001 wt%, preferably at least 0.005 wt%, and more preferably at least 0.01 wt%. In general, the surfactant will be present in the compositions in an amount no greater than 5 wt%, preferably no greater than 3 wt%, and more preferably no greater than 2.5 wt%. Thus, the surfactant is typically present in an amount in the range of 0.001 to 5 wt%, preferably 0.005 to 3 wt%, and more preferably 0.01 to 2.5 wt%. Mixtures of surfactants may suitably be used.

When metal ions are present in the pretreatment compositions, it is preferred that they are the metal that is less electropositive than silver on which silver is to be deposited. For example, when the metal that is less electropositive than silver is copper, it is preferred that copper ions are present in the pretreatment composition. In another embodiment, the present invention provides a bath for promoting the adhesion of silver deposited from an immersion plating bath including an azole compound, water, a chelating agent, and a source of copper ions. The source of copper ions may be any that is sufficiently soluble in the pretreatment composition to provide the desired amount of copper ions. Suitable sources of copper ions include, but are not limited to, copper nitrate, copper sulfate, copper chloride, copper acetate, copper gluconate, copper citrate, copper alkanesulfonate, copper arylsulfonatc, and the like. Mixtures of copper ion sources may also be used.

The amount of metal ions added to the pretreatment composition depends upon the particular metal that is less electropositive than silver, the particular azole compound used and the pH of the pretreatment composition. For example, when copper ions are present in the pretreatment composition, they are typically present in an amount up to 1 g/L, and preferably up to 0.05 g/L.

The pretreatment compositions are typically prepared by combining the azole compound and water, along with any suitable acid or base to adjust the pH and any additional components. Such components may be combined in any order.

A metal that is less electropositive than silver is first contacted with the present pretreatment composition. Such contact may be by a variety of means, such as dipping, spraying, flood coating, puddle coating, and the like. A particularly suitable method of contacting with the present pretreatment compositions is spraying in a flood mode,

Suitable metals that are less electropositive than silver include, but are not limited to, zinc, iron, tin, nickel, lead, copper or alloys containing one or more of these metals. It is preferred that the metal is tin, copper or alloys thereof. A particularly suitable alloy is tincopper. In an alternate embodiment, such metal may itself be immersion deposited on a suitable metal underlayer prior to depositing an immersion silver layer according to the present invention. For example, the metal may be tin, such tin deposit being first deposited, such as by immersion, electroless or electrolytic deposition, on copper.

In general, the metal is contacted with the pretreatment composition for a period of time sufficient to increase the adhesion of a subsequently deposited layer of silver by immersion plating. Such period of time depends upon the particular metal and pretreatment composition used. Typically, a contact time of 1 second to 15 minutes is sufficient, preferably 5 seconds to 10 minutes, and more preferably 10 seconds to 5 minutes. A particularly suitable contact time is from 30 seconds to 3 minutes.

After the metal has been contacted with the pretreatment composition, it is optionally rinsed, such as with water, and then optionally dried. Such a rinsing step is preferred.

A layer of silver is next immersion deposited on the pretreated metal. Any immersion silver plating bath may be used in the present invention. Typical immersion silver baths contain one or more sources of silver ions, one or more complexing agents and water. Any water soluble silver salt may be used as the source of silver ions, such as silver nitrate, silver acetate, silver sulfate, silver lactate, silver formate, and the like. Preferably, the source of silver ions is silver nitrate. The source of silver ions is present in an amount sufficient to provide silver ions in solution in a concentration from 0.06 to 32 g/L, preferably from 0.1 to 25 g/L, and more preferably from 0.5 to 15 g/L.

The one or more complexing agents are any which do not form insoluble precipitates under the plating bath conditions employed. Suitable complexing agents include the chelating agents described above for the pretreatment compositions. It will be appreciated by those skilled in the art that a combination of complexing agents may be employed in the immersion silver baths.

The complexing agent may be used in a variety of concentrations but is preferably present in the immersion silver plating baths either in stoichiometrically equivalent amounts (based on the amount of silver ion) or in a stoichiometrie excess so that all the silver ions may be complexed. The term "stoichiometric" as used herein refers to equimolar Preferably, the one or more complexing agents are present in a higher molar concentration than the silver ions. Preferably, the molar ratio of the complexing agent to silver ions is > 1:1, more preferably ≥ 1.2:1, even more preferably ≥ 2.0:1, and still more preferably ≥ 3.0:1. In general, the total amount of the one or more complexing agents is from 0.1 to 250 g/L, preferably from 2 to 220 g/L, more preferably from 10 to 200 g/L, and particularly 50 to 150 g/L.

Immersion silver plating baths useful in the present invention typically have a pH of from 1 to 14. Preferred immersion silver baths have a pH of 1 to 10, and more preferably 2 to 10. A buffering agent may be added to maintain the pH of the immersion silver plating bath at the desired value. Any compatible acids or bases may be used as the buffering agents and may be organic or inorganic. By "compatible" acids or bases it is meant that the acids or bases do not result in precipitation of the silver ions and/or complexing agents from solution, when such acids or bases are used in amounts sufficient to buffer the pH. Suitable buffering agents include, but are not limited to, alkali metal hydroxides such as sodium hydroxide or potassium hydroxide, carbonate salts, citric acid, tartaric acid, nitric acid, acetic acid, phosphoric acid and the like.

The immersion silver plating baths may optionally contain one or more additional components. Suitable additional components include, but are not limited to, surfactants or wetting agents, anti-tarnish agents for silver, oxidation inhibitors, levelers, grain refiners, defoamers, dyes, and the like. When surfactants are used in the present immersion baths, they arc typically used in an amount of from 0.02 to 100 g/L, preferably from 0.1 to 25 g/L, and more preferably from 1 to 15 g/L. Such surfactants may be anionic, cationic, nonionic or amphoteric, The choice of surfactant will depend upon the particular immersion silver plating bath used. Nonionie surfactants are preferred.

Grain refiners are typically added to improve the appearance of the silver deposit. Suitable grain refiners include (C₁-C₆)alcohols and polyalkylene glycols such as polyethylene glycol. Such grain refiners arc typically used in an amount from 0.02 to 200 g/L, and preferably from 0.05 to 100 g/L.

A wide variety of anti-tarnish agents for silver may be used, such as triazoles, tetrazoles, imidazoles, and the like. Such anti-tarnish agents are well known to those skilled in the art. The anti-tarnish agents may be used in an amount from 0.001 to 50 g/L, preferably from 0.005 to 25 g/L, and more preferably from 0.01 to 10 g/L.

Preferably, the immersion silver baths arc free of reducing agents capable of reducing silver ions. It is further preferred that the immersion silver baths are free of cyanide ions and ammonium ions.

The immersion silver baths are typically prepared by combining the above ingredients in any order. Preferably, the baths are prepared by forming a solution of complexing agent in water and adding the source of silver ions to this solution. The optional ingredients may be combined with the solution in any order.

The immersion silver plating baths may be agitated. Any form of agitation may be used. Suitable agitation includes, but is not limited to, stirring, shaking, swirling, aeration, sonication and the like. Stirring may be accomplished by any suitable means, such as with an overhead stirrer, paddle stirrer or stirring bar system. Shaking may be accomplished in a variety of ways, such as by moving the substrate to be silver plated back and forth or side to side within the plating bath. Aeration may be accomplished by bubbling or sparging a gas into the plating bath, or by means of jet spray, such as through whirlpool jets. Sparging may be accomplished by bubbling gas into the bath through a fritted means, such as a tube having a frit composed of glass, poly(tetrafluorocthylene) or other inert material. Any gas may be used such as air, oxygen or an inert gas, and preferably air. In a particular embodiment, aeration is used to agitate the bath. Swirling may be accomplished by moving the bath or the substrate to be plated in a substantially circular motion. It will be appreciated by those skilled in the art that a combination of agitation methods may be employed, such as stirring with aeration.

Prior to silver plating, it is preferred that the metal is cleaned. Cleaning removes oxides and organic contaminants from the metal surface as well as resist residues that may remain from incomplete development of dry film photoresists as well as soldermask residues from copper surfaces. Such cleaning may be by any conventional cleaning processes and/or products. For example, when the metal layer is copper or a copper alloy, it is preferred that the metal layer is cleaned with an acidic cleaning composition. Such cleaning procedures are well within the ability of one skilled in the art. After cleaning, the substrate is typically rinsed, such as with water, and optionally dried.

The azole compound adhesion promoters may optionally be added to the cleaning baths. Such cleaning baths then provide the dual functions of cleaning the metal and acting as a pretreatment composition for subsequent silver plating of the metal. In this way, the need for a separate treatment step is avoided.

The metal layer may be microetched either before or after the cleaning step, and preferably after the cleaning step. Such microetching is accomplished by contacting the metal layer on the substrate with a mieroetching composition, such as sulfuric acid/hydrogen peroxide or an alkali metal persulfate such as sodium or potassium persulfate. When such a microetching step is used, the metal layer may then optionally be rinsed with water or an acid, such as with sulfuric acid, to remove any residues from the cleaning and/or microetching steps.

In another embodiment, the present azole compound adhesion promoters may optionally be added to the microetching composition. Such microetching compositions then provide the dual functions of microetching the metal and acting as a pretreatment, composition for subsequent silver plating of the metal. In this way, the need for a separate treatment step is avoided. Thus, the present invention provides a microetching composition including water, an azole compound, and a microetchant selected from sulfuric acid/hydrogen peroxide or an alkali metal persulfate. The present invention further provides a method of improving the adhesion of a layer of silver deposited from an immersion plating bath including the step of contacting a metal that is less electropositive than silver with a microetching composition including water, an azole compound, and a microetchant selected from sulfuric acid/hydrogen peroxide or an alkali metal persulfate prior to contacting the metal with an immersion silver plating bath to provide a layer of silver.

Silver is deposited according to the present invention by contacting the metal that is less electropositive than silver with the present immersion silver plating baths. Such contact may be by dipping, spraying, flood coating, puddle coating, and the like. When used in vertical plating equipment, it is preferred that the substrate is dipped in the present silver plating bath. When used in horizontal plating equipment, it is preferred that the substrate is contacted with the present silver plating bath by spraying or flooding.

The contact time of the metal with the immersion silver plating bath is that amount sufficient to deposit the desired thickness of silver. Typically, the contact time is from about 10 seconds to 15 minutes, preferably from 20 seconds to 15 minutes, and more preferably from 30 seconds to 12 minutes.

The present immersion silver plating baths may be used at a variety of temperatures. Suitable temperatures include those in the range of from 10° to 70° C, preferably from 15° to 60° C, and more preferably from 20° to 50° C.

The silver deposit typically has a thickness of 35 µin. or less, more typically 30 µin. or less, and even more typically 25 µin. or less. Following deposition, the silver layer may be rinsed such as with water. The silver layer may optionally be dried prior to subsequent processing steps.

In general, the metal that is less electropositive than silver is a metal layer on a substrate. A wide variety of substrates having a layer of a metal that is less electropositive than silver may be plated according to the present invention. Suitable substrates include, but are not limited to, jewelry, decorative objects, object d'art, semiconductor packaging, lead frames, solder bumps, metal powder and printed wiring board substrates. The present invention is particularly suited for depositing a solderable silver finish on a printed wiring board. Further, the present invention provides a method of manufacturing a printed wiring board including the steps of contacting a metal that is less electropositive than silver with an azole compound; and then contacting the metal with an immersion silver plating bath to provide a layer of silver. Such a silver layer provides a solderable finish on the printed wiring board. Such solderable finishes are typically applied to a printed wiring board substrate having pads, through holes and a mask, such as a soldermask. In such a printed wiring board substrate, the exposed pads and through holes generally contain a layer of copper.

In yet another embodiment, the present invention is suitable for providing a printed wiring board substrate having exposed pads and/or through holes including a tin-silver alloy as the solderable finish. Thus, the present invention further provides a method for manufacturing a printed wiring board including the steps of: a) contacting a printed wiring board substrate having pads, through boles, soldermask and a layer of a metal that is less electropositive than tin with an immersion plating bath including a source of tin ions, water and a complexing agent, to form a tin deposit on the metal; b) then contacting the tin plated printed wiring board substrate with an azole compound; c) then contacting the tin with an immersion silver plating bath including a source of silver ions, water and a complexing agent, to form an immersion silver deposit on the tin deposit; and d) heating the silver-tin deposit to form a tin-silver alloy.

A wide variety of post-treatments may be used to treat the silver layer deposited according to the present invention. For example, it is well known that silver, such as in silver films, tarnishes upon prolonged exposure to air. Thus, in certain applications it is desirable to contact the freshly deposited silver layer with a tarnish inhibitor or anti-tarnish agent. Such silver tarnish inhibitors are well-known to those skilled in the art and include those described above. The silver deposit may be contacted with the tarnish inhibitor by any suitable means, such as dipping, spraying, flood coating, puddle coating and the like. The use of a tarnish inhibitor subsequent to plating is not required, but may optionally be used. Other conventional post-treatments may also be advantageously used.

The present invention is particularly suitable for use in the manufacture of a wide variety of electronic devices in addition to printed wiring boards, such as lead frames, semiconductor packaging, lead-free solder bumps on wafers, such as tin-silver and tin-copper-silver solders, and the like.

In a further embodiment, the present invention also reduces the amount of or inhibits the formation of tarnish on subsequently immersion deposited layers of silver. For the reduction of or inhibition of tarnish, it is preferred that an imidazole is used in the pretreatment composition. Suitable imidazoles are those described above. Such imidazoles may be used as a separate pretreatment composition or may be added to any microetching composition used to prepare the surface of the metal that is less electropositive than silver for subsequent silver deposition. Thus, the present invention also provides a method of reducing tarnish of a silver layer deposited from an immersion plating bath including the steps of contacting a metal that is less electropositive than silver with an azole compound prior to contacting the metal with an immersion silver plating bath to provide the layer of silver. The amount of azole compound suitable to reduce or inhibit tarnish of subsequently immersion deposited silver layers is that amount sufficient to provide increased adhesion, as described above.

The present invention is suitable for use in vertical or horizontal plating equipment.

The following examples are presented to further illustrate various aspects of the present invention, but are not intended to limit the scope of the invention in any aspect.

### Example 1 (Comparative)

A pretreatment composition was prepared by combining 100 g/L of nitrilotriacetic acid ("NTA") and 0.05 g/L copper nitrate, which was diluted to volume (1L) with deionized water. The pH of the pretreatment was adjusted to 9.

### Example 2

The procedure of Example 1 was repeated, except that 1 g/L of imidazole was also added to the composition. The pH was again adjusted to 9.

### Example 3

Copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water. After contact with the microetching composition, the copper panels were then submerged in either the pretreatment compositions of Example 1 or Example 2 for 1 minute at room temperature. After pretreatment, the copper panels were rinsed with water for 1 minute.

An immersion silver plating bath was prepared by combining 100 g/L of NTA, water, 6 g/L of picolinie acid, 0,005 g/L of DL-lysine, and 1 g/L of silver nitrate. The pH of the bath was adjusted to 9. The temperature of the bath was approximately 50° C.

The pretreated copper panels were dipped in the immersion silver plating bath for 10 minutes. The thickness of the resulting silver layer on the copper panels for each pretreatment composition was determined by X-ray fluorescence ("XRF") spectroscopy for a number of points on the panel and the data are reported as a range of thicknesses in Table 1.

The silver plated copper panels were also evaluated to determine the adhesion of the silver layer. A 3 x 1 inch (7.6 x 2.5 cm) strip of transparent adhesive tape, Scotch 610 brand available from the 3M Company, Minneapolis, Minnesota, was applied to the surface of each of the silver coated copper panels. The tape was then removed from each panel. Silver deposits having poor adhesion were readily removed by the tape and rated as "failed." Silver deposits having good adhesion were not removed by the tape and rated as "passed." The adhesion results are also reported in Table 1

**Table 1**

| **Pretreatment Composition** | **Thickness Range (µin.)** | **Tape Test** |
|---|---|---|
| Example 1 | 4.71-6.31 | Failed |
| Example 2 | 4.22-4.88 | Passed |

From the above data, it can be seen that pretreatment compositions containing an azole compound provided a much more uniform and adherent silver deposit than that obtained without such azole compound pretreatment.

### Example 4

The procedure of Example 3 was repeated, except that the silver immersion plating bath was prepared by combining 100 g/L of NTA, water, 6 g/L of picolinic acid, 0.001 g/L of hydroxybenzotriazole, and 1 g/L of silver nitrate. The pH of the bath was adjusted to 9. The temperature of the bath was approximately 50° C. The deposit uniformity and tape test data are reported in Table 2.

**Table 2**

| **Pretreatment Composition** | **Thickness Range (µin.)** | **Tape Test** |
|---|---|---|
| Example 1 | 5.01-6.06 | Failed |
| Example 2 | 3.71-4.48 | Passed |

From the above data, it can be seen that pretreatment compositions containing an azole compound provided a much more uniform and adherent silver deposit than that obtained without such azole compound pretreatment.

### Example 5

Four pretreatment compositions, Examples 5-1, 5-2, 5-3 and 5-C, were prepared by combining 100 g/L of NTA and 0.05 g of cuprie ion. The pretreatment compositions of Examples 5-1, 5-2 and 5-3 further contained 1, 5 and 10 g/L of imidazole, respectively. The pretreatment composition of Example 5-C was comparative and contained no imidazole. These solutions were diluted to a final volume of 1 L with deionized water and the pH adjusted to 9.

Four copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water.

Copper panel #1 was submerged in the pretreatment composition of Example 5-C. Copper panel #2 was submerged in the pretreatment composition of Example 5-1, copper panel #3 was submerged in the pretreatment composition of Example 5-2 and copper panel #4 was submerged in the pretreatment composition of Example 5-3.

The four copper panels were next dipped in a silver plating bath containing 1 g/L of silver nitrate, 100g/L of NTA, 6 g/L of picolinic acid, and 0.1 g/L 1-hydroxybenzotriazole. The pH of the bath was adjusted to 9.0 and the bath temperature was 50° C.

Following silver deposition, the panels were placed in an oven set at 95° C and containing a water reservoir for 8 hours for steam testing. At the end of 8 hours, the panels were removed from the oven and visually inspected. Panels #2-4 were found to have significantly less tarnish than panel #1. These data clearly show that the use of imidazole in a pretreatment composition greatly reduces the amount of tarnish on a subsequently immersion deposited layer of silver, as compared to a silver deposit without such pretreatment.

### Example 6

A number of microetch compositions were prepared by combining 800 mL/L DI water, 50 mL/L concentrated sulfuric acid, 50 mL/L hydrogen peroxide and 100 mL/L of a concentrate containing organic acids. The microetch compositions were heated at 40° to 50° C. The pretreatment composition of Example 6-C was comparative and contained no azole compound. The other pretreatment compositions all contained an azole compound. The particular azole compounds and amounts are reported in Table 3.

**Table 3**

| **Pretreatment Composition** | **Azole Compound** | **Amount (g/L)** |
|---|---|---|
| Example 6-C | - | 0 |
| Example 6-1 | Imidazole | 1 |
| Example 6-2 | " | 5 |
| Example 6-3 | " | 10 |
| Example 6-4 | 4-Phenylimidazole | 1 |
| Example 6-5 | " | 5 |

### Example 7

A number of copper panels (2 x 6 inches or 5 x 15 cm) were submerged in a commercially available acid cleaner to remove oxides and organic residues from the copper surface, followed by rinsing with water. Each copper panel was next contacted with a microetching composition of Example 6, as shown in Table 4.

The four copper panels were each next dipped in a silver plating bath containing 1g/L of silver nitrate, 100g/L of NTA, 7 g/L of picolinic acid, and 0.1 g/L 1-hydroxybenzotriazole. The pH of the bath was adjusted to 9.0 and the bath temperature was 50° C. Following silver deposition, the uniformity of the silver deposit was evaluated by XRF spectroscopy and the adhesion of some of the silver deposits was evaluated according to the tape test of Example 3, These data are also reported in Table 4.

**Table 4**

| **Pretreatment Composition** | **Thickness Range of Silver Deposit (µin.)** | **Tape Test** |
|---|---|---|
| Example 6-C | 3.82 - 5.99 | Failed |
| Example 6-1 | 2.35 - 3.37 | Passed |
| Example 6-2 | 2.09 - 3.72 | Passed |
| Example 6-3 | 2.24 - 3.48 | Passed |
| Example 6-4 | 2.03 - 2.91 | Passed |
| Example 6-5 | 1.41 - 2.02 | Passed |

The above data clearly show that pretreatment compositions containing an azole compound provided a much more uniform and adherent silver deposit than that obtained without such azole compound pretreatment.

Following silver deposition, a number of the panels were also placed in an oven set at 95° C and containing a water reservoir for 8 hours for steam testing. At then end of 8 hours, the panels were removed from the oven and visually inspected. The panels that were pretreated with an azole compound, i.e. a composition according to Examples 6-1, 6-2 or 6-3, had significantly less tarnish than the silver layer on the copper panel that was not pretreated with an azole compound. These data clearly show that the use of an azole compound in a microetch composition greatly reduces the amount of tarnish on a subsequently immersion deposited silver layer, as compared to the same silver deposit without such pretreatment.

### Example 8 (Comparative)

A number of copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water.

Immersion silver plating baths were prepared by combining 1 g/L of silver nitrate with 95 g/L EDTA. An additive was added to each bath, as shown in Table 5, Each plating bath was diluted to a final volume of 1 L with deionized water. The pH of each bath was adjusted to 7.4 and the temperature of each bath was approximately 50° C.

Cleaned and microetched copper panels were dipped in each of the immersion silver plating baths. The panels remained in the plating bath for 10 minutes. Following silver plating, the panels were rinsed, the appearance of the silver deposit was visually evaluated, and the silver deposits evaluated by the tape test of Example 3. The results are reported in Table 5.

**Table 5**

| **Additive** | **Amount (g/L)** | **Thickness Range of Silver Deposit** (µin.) | **Deposit Appearance** | **Tape Test** |
|---|---|---|---|---|
| None | - | 9.5-13.5 | Dark | Failed |
| 1-(2-Hydroxyethyl)-2-imidazolidinethione | 0.1 | 3.8 - 5.3 | Dark | Failed |
| 6-Aminoindazole | 0.015 | 5.9 - 8.0 | Slightly discolored | Failed |
| 2-Guanidinobenzimidazole | 0.1 | 2.7 - 3.4 | Slightly dark | Failed |
| 2-Imidazolecarboxaldehyde | 0.03 | 7.11-11.17 | Mostly brown | Failed |
| DL-Methionine | 3.3 | 3.4 - 5.5 | Dark | Failed |
| Succinimide | 10 | 3.19 - 4.33 | Dark | Failed |
| 2,2'-Dipyridylamine | 1.5 | 4.04 - 5.80 | Brown | Failed |
| 2,2'-Dipyridyl | 0.15 | 2.54 - 4.61 | Brown | Failed |

The above data clearly show that azole compounds in the immersion silver plating bath do not provide increased adhesion as compared to azole compounds used in the pretreatment compositions of the present invention.

### Example 9

A printed wiring board substrate having exposed copper pads and/or copper plated through holes and a soldermask is contacted with a pretreatment composition containing 95 g/L of EDTA, water, 1 g/L of imidazole and 0.05 of copper nitrate. The substrate is then rinsed with water and is then contacted with a silver plating bath containing 95 g/L of EDTA, water and 1g/L of silver nitrate at a temperature of approximately 50° C. A layer of silver is then immersion deposited on the exposed copper pads and/or copper plated through holes.

### Example 10

The procedure of Example 9 is repeated, except that the imidazole is present in a 1:1 v/v sulfuric acid/hydrogen peroxide microetching composition.

### Example 1

A printed wiring board substrate having exposed copper pads and/or copper plated through holes and a soldermask is contacted with a pretreatment composition containing 100 g/L of NTA, 0.05 g/L copper nitrate, and 1 g/L of imidazole, diluted to volume (1L) with deionized water and having a pH of 9. The substrate is then rinsed with water and is then contacted with a silver plating bath containing 100 g/L of NTA, water and 1g/L of silver nitrate at a temperature of approximately 50° C. A layer of silver is then immersion deposited on the exposed copper pads and/or copper plated through holes.

## Claims

1. A method of improving the adhesion of a layer of silver deposited from an immersion plating bath comprising the step of: contacting a metal that is less electropositive than silver with an azole compound prior to contacting the metal with an immersion silver plating bath.

2. A method of depositing a layer of silver on a substrate comprising the steps of: contacting a metal that is less electropositive than silver with an azole compound; and then contacting the metal with an immersion silver plating bath.

3. A method of manufacturing a printed wiring board comprising the steps of: contacting a metal that is less electropositive than silver with an etchant composition; contacting the metal with an azole compound; and then contacting the metal with an immersion silver plating bath to provide a layer of silver.

4. A method of improving the adhesion of a layer of silver deposited from an immersion bath comprising the step of: contacting a metal that is less electropositive than silver with a microetching composition including water, an azole compound, and a microetchant selected from sulfuric acid/hydrogen peroxide or an alkali metal persulfate, prior to contacting the metal with an immersion silver plating bath to provide the layer of silver.

5. A method for manufacturing a printed wiring board comprising the steps of: a) contacting a printed wiring board substrate having pads, through holes, soldermask and a layer of a metal that is less electropositive than tin with an immersion plating bath including a source of tin ions, water and a complexing agent, to form a tin deposit on the metal; b) then contacting the tin plated printed wiring board substrate with an azole compound; c) then contacting the tin with an immersion silver plating bath including a source of silver ions, water and a complexing agent, to form an immersion silver deposit on the tin deposit; and d) heating the silver-tin deposit to form a tin-silver alloy.

6. The method of any one of claims 1 to 5 wherein the azole compound is selected from triazoles, benzotriazoles, tetrazoles, imidazoles, benzimidazoles, indazoles or mixtures thereof.

7. The method of any one of claims 1 to 6 wherein the azole compound is selected from methylimidazole, cthylimidazole, propylimidazole, hexylimidazole, decylimidazole, undecylimidazole, 1-phenylimidazole, 4-phenylimidazole, hydroxybenzotriazole, aminobenzotriazole, 2-imidazolecarboxaldehyde, benzotriazolecarboxylic acid, 2-guanidinobenzimidazole, 2-aminoindazole, chlorobenzotriazole, hydroxyethylbenzotriazole, hydroxyethylimidazole, hydroxybenzimidazole or 1,2,4-triazole.

8. The method of any one of claims 1 to 7 wherein the azole compound is present in a pretreatment composition in an amount from 0.005 to 50 g/L.

9. The method of any one of claims 1 to 8 wherein the metal that is less electropositive than silver is selected from zinc, iron, tin, nickel, lead, copper or alloys thereof.

10. A method of reducing tarnish of a layer of silver deposited from an immersion bath comprising the step of: contacting a metal that is less electropositive than silver with an imidazole compound prior to contacting the metal with an immersion silver plating bath to provide the layer of silver.
